# EUROPEAN PATENT APPLICATION

(11) **EP 4 283 603 A1**
(43) Date of publication of application: **29.11.2023**
(21) Application number: 22926314.0
(22) Date of filing: 29.04.2022
(51) Int. Cl.: G09G 3/32, G09F 9/33

(54) **LIGHT-EMITTING PIXEL LAYOUT STRUCTURE, DISPLAY PANEL, AND ELECTRONIC DEVICE**

(30) Priority: 28.02.2022 CN 202210191520
(71) Applicant: Changchun Cedar Electronics Technology Co., Ltd, Changchun, Jilin 130103 (CN)
(72) Inventor: ZHENG, Xifeng, Changchun, Jilin 130103 (CN); WANG, Ruiguang, Changchun, Jilin 130103 (CN); WANG, Yang, Changchun, Jilin 130103 (CN); XING, Fanyang, Changchun, Jilin 130103 (CN); CHEN, Yu, Changchun, Jilin 130103 (CN); CAO, Hui, Changchun, Jilin 130103 (CN)
(74) Representative: Ipside
(86) International application number: PCT/CN2022/090734
(87) International publication number: WO 2023/159764

(57) **Abstract**

The present disclosure provides a light-emitting pixel layout structure, a display panel and an electronic device, relating to the technical field of display technology, which solves the problem of display image deformation caused by layout of existing light-emitting diode (LED) pixels. Light-emitting pixels include primary color pixels 101, primary color pixels 102 and primary color pixels 103, the layout structure includes homogeneous primary color rows arranged in an interlaced manner and heterogeneous primary color rows formed by alternate layout of the other two primary color pixels. The present disclosure is applicable to any existing display structure that uses a plurality of point or block light sources as light-emitting pixels. The present disclosure can improve the clarity of a display screen, avoid display deformation, avoid color lines at edges after cutting, obtain a high pixel resolution, and improve the degree of fusion of image edges.

## Description

### Technical Field

The present disclosure relates to the field of a display technology, and in particular to a pixel layout technology.

### Background of the Invention

At present, high-density and fine-pitch (light-emitting diode) LED, Mini LED and Micro LED display technologies have all become hot topics in new display industries, and the performance of display products has also become a common focus of attention for users and industries. Without considering brightness, contrast, stability and uniformity, main factors affecting the image clarity of a high-density LED display screen include space resolution, image hierarchy, a degree of optical crosstalk of pixel light field, a degree of fusion of image edges, and the like, where the image space resolution in LED display is equivalent to the layout density of LED pixels.

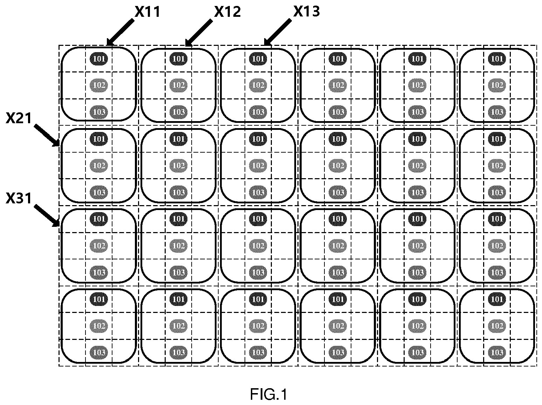

The layout of a traditional LED display panel is shown in FIG. 1, basic pixels X are composed of three primaries, i.e. R, G, B. Three primary colors are divided into primary colors 101, primary colors 102 and primary colors 103, where X11 represents basic pixels of the first row and first column in the panel, X12 represents basic pixels of the first row and second column in the panel, X21 represents basic pixels of the second row and first column in the panel, and so on. In order to maintain an equal distance around LED pixels, the distance between the left and right sides of an individual pixel is relatively large. At the same time, in order to ensure that primary colors in pixels are relatively concentrated, the distribution of primary colors of the panel is also uneven, and the distance between pixels is relatively large. FIG. 1 shows a conventional form of layout of an LED display panel, where it can be seen that each LED pixel occupies nine basic units, the distance between LED pixels is three basic units, and the layout density of LED pixels is lower, resulting in unsatisfactory image clarity of an LED display screen.

The patent literature CN101950513A "LED Display Screen and Control Method thereof" (Publication Date: January 19, 2011) discloses an LED display including three colors of RGB. Every adjacent three rows of sub-pixels constitute a layout cycle, a middle row in each layout cycle is taken as a homogeneous primary color row, and the other two rows are formed by sub-pixels of the remaining two colors arranged at equal intervals. One sub-pixel in the second row serves as a reference, which is combined with two sub-pixels closest in the first row to constitute a triangle to form a pixel, and is also combined with two sub-pixels closest in the third row to constitute a triangle to form a pixel. The two pixels are multiplexed at different times in the previous and next rows to form a double virtual display effect. This layout manner breaks through the principle of centralized layout of primaries and increases the pixel layout density. However, in this patent, every adjacent three rows constitute a layout cycle, primary colors in the middle row are multiplexed in the previous and next rows, and the layout of display units in the vertical direction is uneven, this can easily cause display image deformation.

### Summary of the Invention

In order to solve the problem of display image deformation caused by layout of LED pixels in the prior art, the present disclosure provides a light-emitting pixel layout structure.

The technical solutions of the present disclosure are as follows:
A light-emitting pixel layout structure is provided. Light-emitting pixels include primary color pixels 101, primary color pixels 102 and primary color pixels 103. The layout structure includes homogeneous primary color rows arranged in an interlaced manner and heterogeneous primary color rows formed by alternate layout of the other two primary color pixels, each primary color pixel in the homogeneous primary color row and two adjacent different primary color pixels in a previous row form a triangular structure, and the primary color pixel and two adjacent different primary color pixels in a next row form a triangular structure.

Preferably, the homogeneous primary color row includes primary colors 101, primary colors 102 or primary colors 103.

Preferably, layout sequences of primary color pixels in two heterogeneous primary color rows adjacent to the homogeneous primary color rows are opposite.

Preferably, the triangle is an isosceles triangle.

Preferably, the triangle is an equilateral triangle.

Preferably, the triangle is an isosceles triangle with a length of a bottom side being twice of its height.

Preferably, the light-emitting pixel is any one of light-emitting units or a light-emitting assembly composed of a plurality of light-emitting units.

Preferably, the light-emitting unit is any one of a light-emitting diode (LED), an organic light-emitting diode (OLED) or a liquid crystal display (LCD).

The present disclosure further provides a display panel, including the light-emitting pixel layout structure as described above.

The present disclosure further provides an electronic device, including the display panel as described above.

Compared with the prior art, the present disclosure solves the problem of display image deformation caused by layout of light-emitting pixels in the prior art. Specifically, the present disclosure has the following beneficial effects:
1. Compared with a pixel layout structure in a conventional LED display panel, the layout structure provided by the present disclosure is small in distance between primary color pixels, high in layout density, uniform in distribution of pixel points, uniform in luminescence and good in display effect, improves the image clarity of a display screen, and avoids the problem of display image deformation.
2. In practical applications, an existing light-emitting pixel layout structure needs to be cut according to the size of a display screen to be produced, or a plurality of light-emitting pixel layout structures need to be spliced. However, during the splicing process, there is a problem of color lines appearing at spliced edges of two adjacent light-emitting pixel layout structures, which affects the display effect of the entire display screen. This problem needs to be solved in this field, but is not effectively solved. The light-emitting pixel layout structure described in the present disclosure adopts a very ingenious structural design, so that a display screen formed by cutting or splicing the light-emitting pixel layout structure provided by the present disclosure can ensure that the cut edges are structures with three primary colors arranged at intervals, so as to effectively avoid the problem of color lines at edges after cutting.
3. For the light-emitting pixel layout structure provided by the present disclosure, different display units may be arranged, and then, an existing scanning driving method may be used for achieving driving.

The light-emitting pixel layout structure described in the present disclosure is applicable to any existing display structure that uses a plurality of point or block light sources as light-emitting pixels, especially to display structures that use LEDs as light-emitting pixels.

### Brief Description of the Drawings

FIG. 1 is a schematic diagram of a pixel layout structure in an existing LED display panel in the background art.
FIG. 2A-2C is a schematic diagram of a pixel layout structure provided by the present disclosure, where FIG. 2A shows a layout structure with primary colors 102 as homogeneous primary color rows, FIG. 2B shows a layout structure with primary colors 101 as homogeneous primary color rows, and FIG. 2C shows a layout structure with primary colors 103 as homogeneous primary color rows.
FIG. 3 is a schematic diagram of a pixel layout structure during panel cutting in Embodiment 3.
FIG. 4 is a schematic diagram of a pixel layout structure of an isosceles triangle with a length of a bottom side being twice of its height in Embodiment 4.
FIG. 5 is a schematic diagram of a control method in Embodiment 5.
FIG. 6 is a schematic diagram of a display center of virtual display in Embodiment 5.

### Detailed Description of Embodiments

In order to make the technical solutions of the present disclosure clearer, the technical solutions in embodiments of the present disclosure are clearly and completely described below with reference to the accompanying drawings in the specification of the present disclosure. It should be noted that the following embodiments are only used for better understanding the technical solutions of the present disclosure, but should not be understood as the limitation of the present disclosure.

### Embodiment 1

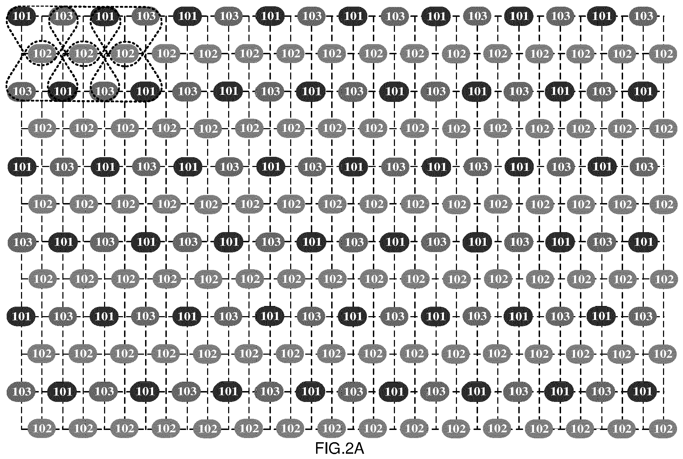

This embodiment provides a light-emitting pixel layout structure. Light-emitting pixels include primary color pixels 101, primary color pixels 102 and primary color pixels 103. The light-emitting pixel is any one of light-emitting units or a light-emitting assembly composed of a plurality of light-emitting units. The layout structure includes homogeneous primary color rows arranged in an interlaced manner and heterogeneous primary color rows formed by alternate layout of the other two primary color pixels. Each primary color pixel in the homogeneous primary color row and two adjacent different primary color pixels in a previous row form a triangular structure with a vertex at the bottom, and the primary color pixel and two adjacent different primary color pixels in a next row form a triangular structure with a vertex at the top. Vertex of the triangle with a vertex at the bottom and the triangle with a vertex at the top are the same primary color pixel, which can be better understood with reference to FIG. 2A. The dashed box in the figure shows the triangular structure with a vertex at the bottom and the triangular structure with a vertex at the top described in this embodiment. For example, with reference to FIG. 2A, taking the first pixel on the left side of the homogeneous primary color row as an example: the first primary color pixel 102 on the left side of the homogeneous primary color row, which is taken as a vertex, and the first primary color pixel 101 and primary color pixel 103 in the first row form a triangle with a vertex at the bottom, then, the first primary color pixel 102 in the homogeneous primary color row, which is taken as a vertex, and the first primary color pixel 103 and primary color pixel 101 in the third row form a triangle with a vertex at the top, and so on.

The light-emitting unit described in this embodiment is any one of an LED, an OLED or an LCD, or may also be any one of existing light-emitting components.

Compared with a pixel layout structure in a conventional LED display panel, the layout structure provided in this embodiment is small in pixel pitch and high in pixel layout density. Compared with the prior art, the image clarity of a display screen is improved, and pixels are uniformly distributed in both horizontal and vertical directions, thereby avoiding the problem of display image deformation.

### Embodiment 2

This embodiment is a further illustration of the light-emitting pixel layout structure in Embodiment 1, where the homogeneous primary color row may include primary colors 101, primary colors 102 or primary colors 103.

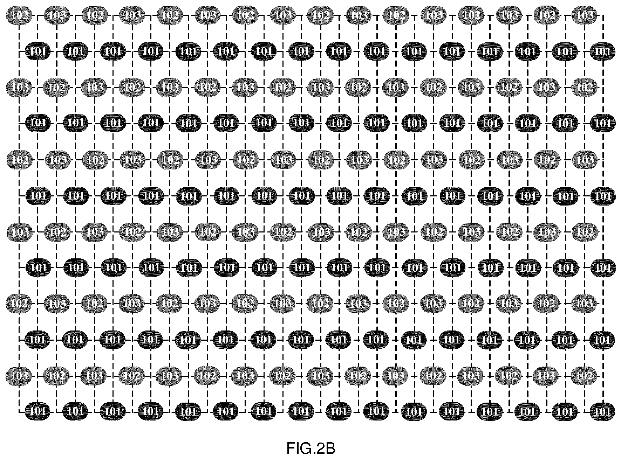

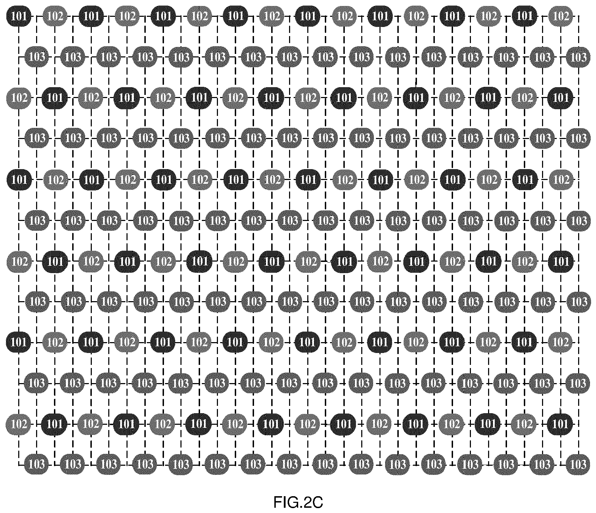

The pixel layout structure in this embodiment does not specifically limit the selection of the homogeneous primary color row. FIG. 2A only shows one layout manner taking the row of primary colors 102 as the homogeneous primary color row, but this embodiment is not limited to this layout. The row of primary colors 101 may be taken as the homogeneous primary color row for layout, as shown in FIG. 2B, or the row of primary colors 103 may be taken as the homogeneous primary color row for layout, as shown in FIG. 2C.

### Embodiment 3

This embodiment is a further illustration of the light-emitting pixel layout structure in Embodiment 1, where layout sequences of primary color pixels in two heterogeneous primary color rows adjacent to the homogeneous primary color rows are opposite.

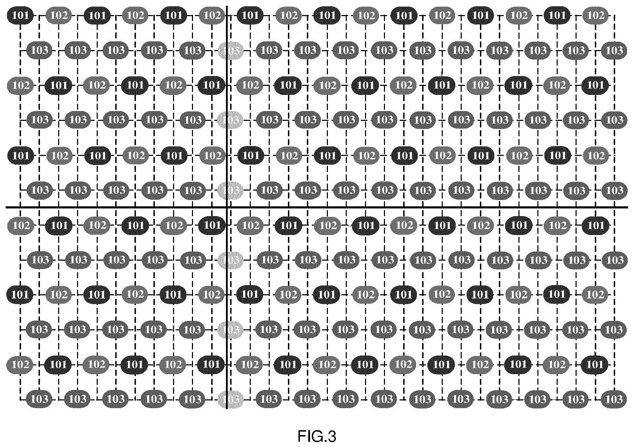

The present disclosure does not limit the layout sequences of primary color pixels in two heterogeneous primary color rows adjacent to the homogeneous primary color row. Regardless of whether the layout sequences are the same or opposite, the accuracy of the display colors can be ensured. As a preferred solution, the layout structure of this embodiment takes the case where the row of primary colors 103 is taken as the homogeneous primary color row as an example. During panel cutting, the pixel layout is shown in FIG. 3. In the figure, solid lines represent cutting lines, and it can be seen that three primary color pixels are alternately arranged at the cut edges of the cutting lines. Compared with a layout manner in which layout sequences of primary color pixels in two heterogeneous primary color rows adjacent to the homogeneous primary color row are the same, this embodiment can effectively avoid the problem of color lines appearing at the cut edges, and the cut edges can be displayed normally. Actually, after the layout structure described in this embodiment is cut, three primary color pixels are alternately arranged at the positions of four edges, so the edges are not affected by cutting.

### Embodiment 4

This embodiment is a further illustration of the light-emitting pixel layout structure in Embodiments 1 to 3, where the triangle is an isosceles triangle.

The present disclosure can achieve the accuracy of the display colors without limiting the shape of the triangle. The isosceles triangle described in this embodiment is used as a preferred solution, so that the distances between each primary color pixel in the homogeneous primary color row and two adjacent different primary color pixels in an adjacent row are equal. Compared with the layout of a scalene triangle, this layout structure is more uniform in distribution of primary color pixels and improved in impression.

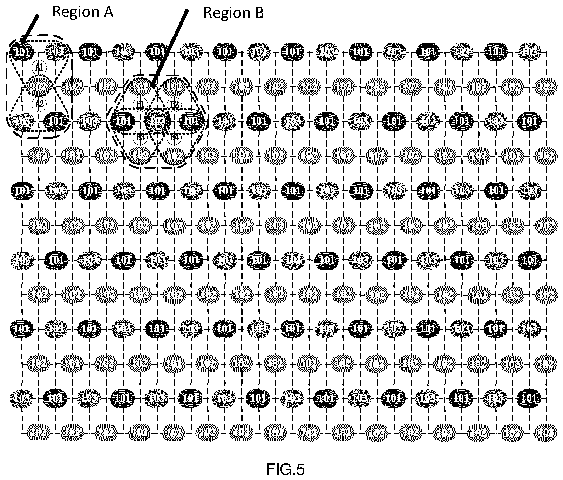

Based on the isosceles triangle layout structure, this embodiment further provides a more preferred layout structure, where the triangle is an equilateral triangle. Taking the layout structure with the row of primary colors 102 as the homogeneous primary color row as an embodiment, the advantages of this structure are illustrated with reference to FIG. 5. One primary color pixel in the homogeneous primary color row and two adjacent different primary color pixels in an adjacent heterogeneous primary color row form an equilateral triangle. All equilateral triangles with a vertex at the bottom and equilateral triangles with a vertex at the top correspond to virtual pixel points. For example, illustrated by a region A in the figure, an equilateral triangle with the primary color pixel 102 as a vertex at the top and an equilateral triangle with the primary color pixel 102 as a vertex at the bottom respectively correspond to two virtual pixel points, that is, the primary color pixel 102 is multiplexed twice. Illustrated by a region B in the figure, two equilateral triangles with the primary color pixel 102 as a vertex at the top and two equilateral triangles with the primary color pixel 102 as a vertex at the bottom respectively correspond to four virtual pixel points, that is, the primary color pixel 103 is multiplexed four times. Due to a large number of multiplexing of pixels, the display resolution is high. Moreover, the pixel points corresponding to this solution have the same distance in both horizontal and vertical directions, and this uniform distribution results in better display effect, uniform luminescence and better impression.

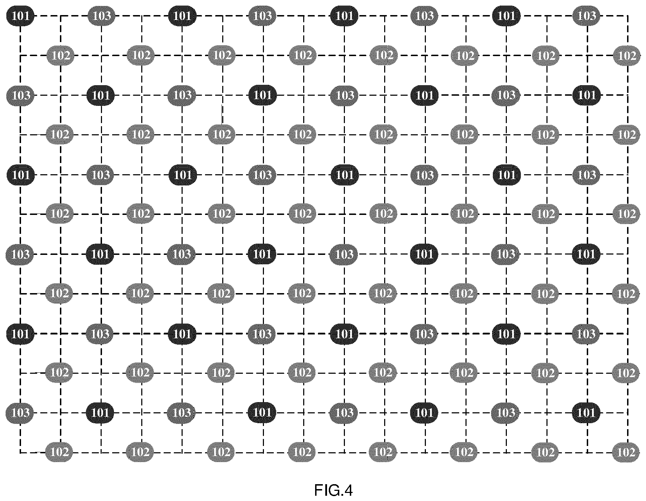

Based on the isosceles triangle layout structure, this embodiment further provides another more preferred layout structure, where the triangle is an isosceles triangle with a length of a bottom side being twice of its height. Taking the case where the row of primary colors 102 is taken as the homogeneous primary color row as an example, the layout manner described in this embodiment is shown in FIG. 4, one primary color pixel in the homogeneous primary color row and two adjacent different primary color pixels in an adjacent heterogeneous primary color row form an isosceles triangle, and a length of a bottom side of the triangle is twice of its height. Each primary color pixel in the homogeneous primary color row and two adjacent different primary color pixels in the previous row or next row form an isosceles triangle, and each isosceles triangle corresponds to virtual pixel points. For example, illustrated by a region A in the figure, each equilateral triangle with the primary color pixel 102 as a vertex at the bottom corresponds to one virtual pixel point, that is, the primary color pixel 102 is not multiplexed, but the primary color pixels 101 and 103 are multiplexed two times. Due to a small number of multiplexing of pixels, driving manner is simple and fast. Moreover, the pixel points corresponding to this solution have the same distance in both horizontal and vertical directions, and this uniform distribution results in better display effect, uniform light emission and a better viewing experience.

### Embodiment 5

This embodiment provides a control method of the light-emitting pixel layout structure in Embodiments 1 to 5, thereby proving that the light-emitting pixel layout structure described in the present disclosure can achieve a display function. The control method for multiplexing of pixels in this embodiment is as follows:

A triangular structure formed by each primary color pixel in the homogeneous primary color row and two adjacent different primary color pixels in the previous row in the structure is used as a display unit, at the same time, a triangular structure formed by each primary color pixel in the homogeneous primary color row and two adjacent different primary color pixels in the next row is used as a display unit, and the two display units multiplex one primary color pixel. All display units form a matrix display structure. The control method can complete the display of one frame of display picture through four times of progressive scanning: the first time of scanning is to drive each primary color pixel in display units of odd rows and odd columns, the second time of scanning is to drive each primary color pixel in display units of odd rows and even columns, the third time of scanning is to drive each primary color pixel in display units of even rows and odd columns, and the fourth time of scanning is to drive each primary color pixel in display units of even rows and even columns, thereby completing the virtual display of one frame of picture.

More specifically, there is a corresponding mapping relationship between the matrix display structure formed by all display units and pixel points of an image source. Firstly, a brightness data signal of each pixel point of the image source is scanned and collected, and then, a display panel is driven and controlled according to the corresponding mapping relationship. Four times of scanning are performed according to the above method to drive each primary color pixel in display units, so that each primary color pixel is displayed according to the brightness data corresponding to the pixel points of the image source to achieve the virtual display of one frame of picture.

As shown in FIG. 5, taking a layout structure with the row of primary colors 102 as the homogeneous primary color row as an example, a region A is defined with one primary color pixel 102 as a center, a region B is defined with one primary color pixel 103 in the heterogeneous primary color row as a center, and each display unit in each region is a display unit composed of three primary color pixels. As shown in dashed boxes in the figure, the center position of each display unit is a display center. In the region A, the display center of the first display unit is A1, which is the center position of three primary color pixels of the first triangular display unit, A2 is the display center of the second display unit, and so on. In the region B, the center of the first display unit is B1, the center of the second display unit is B2, the center of the third display unit is B3, and the center of the fourth display unit is B4. Since the display unit of the triangle is an equilateral triangle, it can be seen that the distance between all display centers in horizontal and vertical directions is equal, and is equal to a side length of the triangle. The distribution of the display centers corresponds to the distribution of the pixel points, and this uniform distribution results in good display effect, uniform luminescence and low visual fatigue.

It can be seen from FIG. 5 that the primary color pixels in the homogeneous primary color row are multiplexed twice by two adjacent triangular display units in the previous and next rows. For example, the display unit with A1 as the display center and the adjacent display unit with A2 as the display center multiplex the primary color pixels 102 in the homogeneous primary color row; the primary color pixels in the heterogeneous primary color row are multiplexed four times by four adjacent triangular display units; and the display unit with B1 as the display center and the adjacent display unit with B2 as the display center as well as the display unit with B3 as the display center and the adjacent display unit with B4 as the display center multiplex the primary color pixels 103 in the heterogeneous primary color row.

The control method for multiplexing of pixels provided in this embodiment achieves the virtual display of one frame through four times of progressive scanning. The first time of scanning achieves the driving display of pixel data in display units of odd rows and odd columns, the second time of scanning achieves the driving display of pixel data in display units of odd rows and even columns, the third time of scanning achieves the driving display of pixel data in display units of even rows and odd columns, and the fourth time of scanning achieves the driving display of pixel data in display units of even rows and even columns.

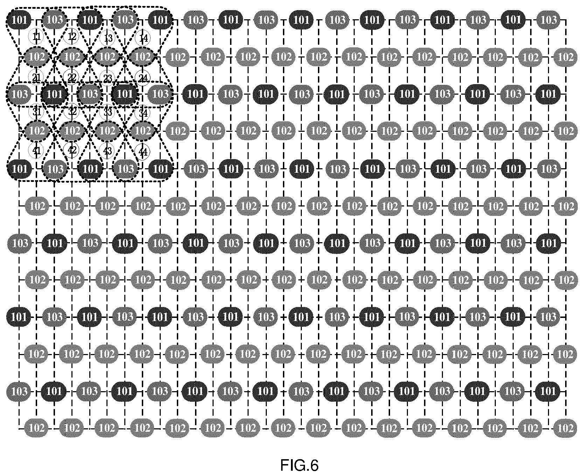

For example, with reference to FIG. 6, first scanning control process: progressive scanning is performed to drive brightness data signals of three primary color pixels corresponding to display units with 11, 13, 31, 33, ..., as display centers; second scanning control process: progressive scanning is performed to drive brightness data signals of three primary colors corresponding to display units with 12, 14, 31, 34, ..., as display centers; third scanning control process: progressive scanning is performed to drive brightness data signals of three primary colors corresponding to display units with 21, 23, 41, 43, ..., as display centers; and fourth scanning control process: progressive scanning is performed to drive brightness data signals of three primary colors corresponding to display units with 22, 24, 42, 44, ..., as display centers.

By using the multiplexing control method provided in this embodiment, the driving of data signals is completed through four times of progressive scanning for one frame of display picture. It is possible to multiplex each primary color pixel in the homogeneous primary color row twice, and multiplex each primary color pixel in the heterogeneous primary color row four times, thereby achieving the virtual display with 11, 12, 13, 14, ..., 21, 22, 23, 24, ..., 31, 32, 33, 34, ..., 41, 42, 43, 44, ..., as display centers as shown in FIG. 6.

## Claims

1. A light-emitting pixel layout structure, wherein light-emitting pixels comprise primary color pixels 101, primary color pixels 102 and primary color pixels 103, the light-emitting pixel layout structure comprises homogeneous primary color rows arranged in an interlaced manner and heterogeneous primary color rows formed by alternate layout of the other two primary color pixels, each primary color pixel in the homogeneous primary color row and two adjacent different primary color pixels in a previous row form a triangular structure, and the primary color pixel and two adjacent different primary color pixels in a next row form a triangular structure.

2. The light-emitting pixel layout structure according to claim 1, wherein the homogeneous primary color row comprises primary colors 101, primary colors 102 or primary colors 103.

3. The light-emitting pixel layout structure according to claim 1, wherein layout sequences of primary color pixels in two heterogeneous primary color rows adjacent to the homogeneous primary color rows are opposite.

4. The light-emitting pixel layout structure according to claim 1, wherein the triangle is an isosceles triangle.

5. The light-emitting pixel layout structure according to claim 4, wherein the triangle is an equilateral triangle.

6. The light-emitting pixel layout structure according to claim 4, wherein the triangle is an isosceles triangle with a length of a bottom side being twice of its height.

7. The light-emitting pixel layout structure according to claim 1, wherein the light-emitting pixel is any one of light-emitting units or a light-emitting assembly composed of a plurality of light-emitting units.

8. The light-emitting pixel layout structure according to claim 7, wherein the light-emitting unit is any one of a light-emitting diode (LED), an organic light-emitting diode (OLED) or a liquid crystal display (LCD).

9. A display panel, comprising the light-emitting pixel layout structure according to claim 1.

10. An electronic device, comprising the display panel according to claim 9.
